Europäisches Patentamt

European Patent Office

Office européen des brevets

(19)

(11) EP 0 939 446 A1

(12) EUROPÄISCHE PATENTANMELDUNG

(43) Veröffentlichungstag:
01.09.1999 Patentblatt 1999/35

(51) Int. Cl.⁶: **H01L 29/08**, H01L 29/78,
H01L 29/739

(21) Anmeldenummer: 99102696.4

(22) Anmeldetag: 12.02.1999

(84) Benannte Vertragsstaaten:
AT BE CH CY DE DK ES FI FR GB GR IE IT LI LU
MC NL PT SE
Benannte Erstreckungsstaaten:
AL LT LV MK RO SI

(30) Priorität: 27.02.1998 DE 19808348

(71) Anmelder:
SIEMENS AKTIENGESELLSCHAFT
80333 München (DE)

(72) Erfinder:
• Deboy, Gerald, Dr.
  82008 Unterhaching (DE)
• Stengl, Jens-Peer
  82284 Grafrath (DE)
• Tihanyi, Jenö, Dr.
  85551 Kirchheim (DE)
• Graf, Heimo
  9711 Paternion (AT)

(54) **Durch Feldeffekt steuerbares Leistungshalbleiterbauelement**

(57)   Die Erfindung betrifft ein durch Feldeffekt steuerbares Leistungs-Halbleiterbauelement, das eine Vielzahl von parallel geschalteten und jeweils in Zellen angeordneten Einzelbauelementen aufweist, wobei die Zellen in einem Zellenfeld auf relativ kleinem Raum dicht gepackt angeordnet sind. Die parallel geschaltenen Source-Zonen der Zellen weisen Abschattungsbereiche auf, die jeweils in den Abschattungsbereiche enthaltenden Zellen das effektive W/L-Verhältnis reduzieren. Die Erfindung weist den Vorteil auf, daß durch Vorsehen von Abschattungsbereichen innerhalb der Sourcezonen, die vorzugsweise undotiert sind bzw. zumindest sehr viel niedriger dotiert sind als die Sourcezonen, die kritischen Bereiche im Zellenfeld mit der höchsten Stromdichte gezielt entschärft werden und somit die Stromdichte in stromführenden Filament der Zelle homogener verteilt wird. Durch diese Maßnahme läßt sich das Zellraster L der Zellen im Zellenfeld verringern bzw. der flächenbezogenen Durchlaßwiderstand verringert werden, was gleichzeitig zu einer Verringerung der Verlustleistung führt.

FIG 2

## Beschreibung

Die Erfindung betrifft ein durch Feldeffekt steuerbares Leistungs-Halbleiterbauelement, das eine Vielzahl von parallel geschalteten und jeweils in Zellen angeordneten Einzelbauelementen aufweist, wobei die Zellen in einem Zellenfeld auf relativ kleinem Raum dicht gepackt angeordnet sind, bestehend aus einem Halbleiterkörper,

a) mit mindestens einer Innenzone vom ersten Leitungstyp, die mindestens teilweise an eine erste Oberfläche des Halbleiterkörpers angrenzt,

b) mit mindestens einer Drain-Zone, die an die Innenzone angrenzt,

c) mit mindestens einer in jeder der Zellen angeordneten Basiszone vom zweiten Leitungstyp, die an der ersten Oberfläche in den Halbleiterkörper eingebettet sind,

d) mit mindestens einer in jeder der Zellen angeordneten Source-Zone vom ersten Leitungstyp, die in den Basiszonen eingebettet sind,

e) mit mindestens einer Source-Elektrode, die jeweils die Basiszonen und die darin eingebetteten Source-Zonen kontaktiert,

f) mit mindestens einer gegen den gesamten Halbleiterkörper isolierten Gate-Elektrode.

Derartige durch Feldeffekt steuerbare Halbleiterbauelemente gehören schon seit langem zum Stand der Technik. Zum einen sind sie als MOS-Feldeffekttransistoren bekannt, sofern die an die Innenzone angrenzende Drainzone vom selben Leitungstyp wie die Innenzone ist. Zum anderen sind solche durch Feldeffekt steuerbare Halbleiterbauelemente als IGBTs bekannt, sofern die Drainzone als Anodenzone ausgebildet ist und vom entgegengesetzten Leitungstyp ist wie die Innenzone.

Derartige vertikale MOSFETs bzw. IGBTs sind ausführlich beschrieben in Jens Peer Stengl, Jenö Tihanyi, Leistungs-MOSFET-Praxis, 2. Auflage, Pflaum-Verlag, München, 1992.

Aus der US 5,008,725 ist ein gattungsgemäßes Halbleiterbauelement bekannt, bei dem eine Vielzahl von parallel geschalteten und jeweils in Zellen angeordneten Einzelbauelementen dicht gepackt in einem Zellenfeld angeordnet ist.

Allen eingangs genannten Halbleiterbauelementen ist der Nachteil inhärent, daß der flächenbezogene Durchlaßwiderstand $RDS_{on}$, d. h. der Widerstand zwischen Drainanschluß und Sourceanschluß im eingeschalteten Zustand, mit zunehmender Spannungsfestigkeit des Halbleiterbauelements zunimmt. Die Ursache hierfür liegt in der Dicke der Innenzone, die bei Leistungshalbleiterbauelementen auch als Driftzone bezeichnet wird und die im Wesentlichen die Spannungsfestigkeit bestimmt. Bei angelegter Sperrspannung nimmt die Driftzone die Sperrspannung auf und verhindert so ein unerwünschtes Durchschalten in Sperrichtung. Die Dicke der Driftzone ist somit etwa proportional zu der von der Driftzone aufnehmbaren Sperrspannung und somit zur Spannungsfestigkeit des Leistungshalbleiterbauelements. Bei vertikal ausgebildeten Leistungs-MOSFETs beträgt üblicherweise der flächenbezogene Durchlaßwiderstand $RDS_{on}$ bei einer Spannung von 600 V etwa 12 $\Omega mm^2$.

Zur Reduzierung des flächenbezogenen Durchlaßwiderstandes werden daher dotierungsstrukturierte Bahngebiete in die Driftzone derartiger Halbleiterbauelemente eingebracht. Halbleiterbauelemente mit dotierungsstrukturierten Bahngebieten in der Driftzone sind ausführlich in der WO 97/29518 sowie in der US 4,754,310 beschrieben. Die dort beschriebene Technologie erlaubt eine deutliche Verringerung des flächenbezogenen Durchlaßwiderstandes. Durch Verringerung der Chipfläche lassen sich bei gleichem oder besserem flächenbezogenen Durchlaßwiderstand $RDS_{on}$ sehr kostengünstige Bauelemente herstellen.

In Folge des Einbringens von zusätzlichen Ladungsträgern des entgegengesetzten Leitungstypes in die Driftzone steht jedoch ein deutlich geringerer Teil der aktiven Chipfläche (typischerweise 60%) zum Transport des Laststromes zur Verfügung. Zusätzlich wird im Sättigungsbereich des Kennlinienfeldes, der zum Beispiel beim Schalten induktiver Lasten im Kuszschlußbetrieb durchlaufen wird, infolge der hohen Spannungsaufnahme des Halbleiterbauelementes und der durch die Technologie vorgegebenen dotierungsstrukturierten Bahngebieten ein sehr hohes elektrisches Querfeld aufgebaut, das zu einer zusätzlichen Verengung der aktiven, am Stromfluß beteiligten Chipfläche führt. Die Stromdichte in diesem filamentartigen Stromfaden erreicht infolge dessen Werte im Bereich von einigen kA $cm^{-2}$. Gelangt die für den Durchlaßstrom erforderliche Elektronenkonzentration in den Bereich der Grunddotierung der Driftzone, dann steigt das elektrische Vertikalfeld ebenfalls stark an, wobei dessen Feldverteilung einen als Funktion der Tiefe ansteigenden Verlauf aufweist. Damit sinkt jedoch die Sperrspannung des Halbleiterbauelementes und es kommt zur Ladungsträgergeneration durch Stoßionisation.

Aufgrund dessen wird eine kritische Stromdichte $J_{crit}$ definiert, die die maximal zulässige Stromdichte in der Driftzone angibt und bei der das elektrische Vertikalfeld noch vernachlässigbar gering ist. Die kritische Stromdichte $J_{crit}$ ist dabei wie folgt definiert:

$$J_{crit} \le x \, q \, N_D \, v_{Sat}.$$

Dabei bezeichnet q die Elementarladung, $N_D$ die Dotierungskonzentration in der Driftzone und $v_{Sat}$ die Sättigungsdriftgeschwindigkeit (typischerweise $10^7$ cm sec$^{-1}$). Mit x ist ein sogenannter Verringerungsfaktor angegeben, dessen Wert zwischen 0 und 1 liegt. Typischerweise wird der Verringerungsfaktor x vom Anwender je nach Applikation zwischen 0,1 und 0,2 gewählt.

Um zu vermeiden, daß die kritische Stromdichte erreicht wird, werden in den derzeitig eingesetzten Technologien für Leistungshalbleiterbauelementen, insbesondere Leistungs-MOSFETs, aufgrund des absolut dominierenden Epitaxieanteils am gesamten Durchlaßwiderstand des Halbleiterbauelementes, relativ große Zellraster eingesetzt. Bei einem MOSFET, der für 600 Volt Sperrspannung ausgelegt ist, beträgt der Epitaxieanteil beispielsweise etwa 99% des Durchlaßwiderstandes. Für einen derartigen MOSFET können die einzelnen Zellen ein relativ großes Zellraster von $L_R \ge 40$ µm aufweisen. Mit derartig großen Einzelzellen ist jedoch einerseits die Kanalweite pro eingesetzter Zellfläche relativ gering. Andererseits erlaubt der hohe Gesamtdurchlaßwiderstand des MOSFETs in Folge der Begrenzung der maximal zulässigen Verlustleistung nur einen relativ geringen Durchlaßstrom von typischerweise 6 bis 8 A.

Der vorliegenden Erfindung liegt daher die Aufgabe zugrunde, die eingangs genannten, durch Feldeffekt steuerbaren Halbleiterbauelemente derart weiterzubilden, daß trotz hoher Sperrspannung ein niedriger Durchlaßwiderstand erzielt wird und die im Stand der Technik aufgezeigten Nachteile beseitigt werden.

Erfindungsgemäß wird diese Aufgabe durch ein durch Feldeffekt steuerbares Halbleiterbauelement der eingangs genannten Art gelöst, bei dem

g) zumindest in einer der Source-Zonen der Zellen Abschattungsbereiche vorgesehen sind, h) die dort das effektive W/L-Verhältnis reduzieren, wobei mit W/L-Verhältnis das Verhältnis von Kanalweite W zu Kanallänge L bezeichnet ist.

Die Erfindung weist den Vorteil auf, daß durch Vorsehen von Abschattungsbereichen innerhalb der Sourcezonen, die vorzugsweise undotiert sind bzw. zumindest sehr viel niedriger dotiert sind als die Sourcezonen, die kritischen Bereiche im Zellenfeld mit der höchsten Stromdichte gezielt entschärft werden und somit eine Stromfilamentierung weitgehend vermieden wird.

Durch diese Maßnahme läßt sich das Zellraster $L_R$ der Zellen im Zellenfeld deutlich verringern. Beispielsweise lassen sich Zellstrukturen mit einem Zellraster $Z_R$ kleiner 20 µm realisieren. Durch das Vorsehen von Abschattungsbereichen und durch die Vergrößerung der Zelldichte werden die folgenden Vorteile erzielt:

Das Zellraster bei gattungsgemäßen Halbleiterbauelementen, insbesondere bei Halbleiterbauelementen mit Ausräumzonen und Komplementärausräumzonen, ist nicht frei wählbar. Je kleiner das Zellraster ist, desto größer muß zur Vermeidung eines lateralen Durchbruches die Dotierung in der Driftzone unterhalb der Gateelektrode gewählt werden. Die Drchschaltwiderstand wird zwar kleiner, allerdings wird durch ein enges Zellraster auch die Kanalweite pro Zellfläche und damit der Sättigungsstrom größer. Durch das Vorsehen von Abschattungsbereichen in den Sourcezonen wird die effektive Kanalweite pro Zellfläche verringert und eine Stromfilamentierung in der Driftzone vermieden.

Gattungsgemäße, in Trenchtechnologie hergestellte Halbleiterbauelemente weisen am Trenchboden typischerweise die Bereiche mit der höchsten elektrischen Feldstärke auf, was zu einer starken Belastung des Gateoxides an dieser Stelle führt.

Durch die Verringerung des Zellrasters werden zwar die Feldspitzen des elektrischen Feldes auf ein Minimum verringert, jedoch erhöht sich dadurch der Kurzschlußstrom. Bisher wurde dies gelöst, indem sogenannte tote, das heißt inaktive Trenches zwischen den Gateelektroden angeordnet wurden, was jedoch zu einer Verringerung der Zelldichte führte. Durch die erfindungsgemäßen Abschattungsbereiche wird der Kurzschlußstrom reduziert bei gleichzeitiger hoher Zelldichte.

Bei sogenannten Low-Charge-MOSFETs ist es notwendig, die Gate-Drain-Kapazität (Rückwirkungskapazität $C_{RSS}$) zu verringern. Durch das enge Zellraster, das heißt durch eine hohe Zelldichte, wird zwar die Fläche der Innenzone über der Gateelektrode und damit die Gate-Drain-Kapazität (Rückwirkungskapazität $C_{RSS}$) verringert. Allerdings ist ein enges Zellraster gleichbedeutend mit einer größeren Kanalweite pro Zellfläche und somit mit einem höheren Sättigungsstrom. Durch die erfindungsgemäßen Abschattungsbereiche läßt sich die Sättigungsstromdichte auf einen niedrigen Wert einstellen bei gleichzeitig verringerter Gate-Drain-Kapazität.

Die Abschattungsbereiche sind normalerweise in denjenigen Bereichen der Sourcezone angeordnet, in denen die Ausbildung eines stromführenden Kanals unterbunden oder zumindest verringert werden soll.

Das Zellenfeld des Leistungshalbleiterbauelementes besteht aus einer Vielzahl von typischerweise gleichförmigen, dicht gepackten Zellen. Jede der Zellen enthält dabei üblicherweise jeweils eine Sourcezone, die in die Basiszone eingebettet ist. Es ist selbstverständlich auch möglich, daß eine einzelne Zelle mehrere Basiszonen bzw. mehrere Sourcezonen aufweist. Im bevorzugten Ausführungsbeispiel haben die Querschnittsflächen der Basiszone und der Sourcezone jeweils etwa die Form der Querschnittsfläche der entsprechenden Gesamtzelle.

Besonders vorteilhaft ist es, wenn die Zellen des Zellenfeldes eine hexagonale Querschnittsfläche aufweisen. Die hexagonale Struktur ermöglicht die dichteste Flächenpackung der Zellen, d. h. eine optimale Ausnutzung der Chipfläche. Außerem wird bei der hexagonalen Zellenstruktur ein optimaler Durchlaßwiderstand bei gleichzeitig optimalem Laststrom erreicht.

Eine weitere vorteilhafte Zellstruktur ergibt sich bei Verwendung von etwa quadratischen Zellen bzw. rechteckförmigen oder dreieckigen Zellen. Die Erfindung ist jedoch auch bei andere Zellenanordnungen wie beispielsweise runden oder ovalen Zellen anwendbar.

Typischerweise ist die Sourcezone arsendotiert. Damit im Durchlaßbetrieb ein hoher Laststrom erzielt werden kann, ist es notwendig, daß die Sourcezone eine sehr hohe Dotierungskonzentration von typischerweise größer $10^{18}$ cm$^{-3}$ aufweist. Besonders vorteilhaft ist es dann, wenn die Abschattungsbereiche undotiert sind. In diesem Fall wird die Kanalweite entsprechend der Breite der Abschattungsbereiche im Bereich des pn-Übergangs zwischen Sourcezonen und Basiszone verringert. Das dadurch geringere W/L-Verhältnis der so abgeschatteten Zelle hat zur Folge, daß sich der Stromfluß der Zelle gleichermaßen verringert.

Es ist selbstverständlich auch denkbar, wenngleich auch technologisch aufwendiger, wenn die Abschattungsbereiche eine niedrigere Dotierungskonzentration als die Sourcezone aufweisen. In diesem Fall wird der Stromfluß in den abgeschatteten Bereichen der Sourcezone entsprechend der Dotierungskonzentration verringert. Da der oben beschriebene Fall der undotierten Abschattungsbereiche technologisch sehr schwer zu realisieren ist, weisen die Abschattungsbereiche in der üblichen Realisierung meist den Leitungstyp und die Dotierungskonzentration der Basiszone auf.

Durch Einbringen von Abschattungsbereichen in genau einer der Bereiche der Sourcezone mit minimalem Abstand zueinander lassen sich die kritischen Bereiche, in denen die maximale Stromdichte zu erwarten ist, gezielt entschärfen. Durch ein dreiflügeliges bzw. propellerähnliches Design der Abschattungsmaske insbesondere bei der hexagonalen Zellenstruktur wird jeweils einer der beiden, von den Sourcezonen in die Basiszonen injizierten Stromkanäle abgschattet. Gleichzeitig wird durch eine mehrteilige Form der Maske die Partitionierung des Kanalstroms und somit des daraus resultierenden Stromes unterhalb der Zwischenzellenzonen weitgehend homogen gestaltet. Es wird somit eine wesentlich optimierte, d. h. homogenisierte Stromdichteverteilung im stromführenden Filament der Innenzone gewährleistet.

Durch die dreiflügelige Ausgestaltung der Abschattungsmaske läßt sich eine Abschattung der Sourcezonen bis zu 50 % erzielen. Besonders vorteilhaft ist es jedoch, wenn jeweils einzelne aktive Zellen vorgesehen sind, die keine Abschattungsbereiche aufweisen. Diese aktiven Zellen sind bei einem hexagonalen Zellenlayout umgeben von jeweils sechs inaktiven Zellen, bei denen die jeweiligen Sourcezonen typischerweise vollständig abgeschattet sind. Mit diesem Design des Zellenlayouts läßt sich eine Abschattung der Sourcezonen bis zu 66 % erreichen. Derartige Halbleiterbauelemente weisen eine verbesserte Kurzschlußfestigkeit auf.

Besonders vorteilhaft ist es, wenn die Drainzone dieselbe Dotierung aufweist wie die Innenzone. Das daraus resultierende bevorzugte Halbleiterbauelement ist dann ein Leistungs-MOSFET. Typischerweise weist die Drainzone bei derartigen Leistungs-MOSFET, die üblicherweise durch das Bulkmaterial des Halbleiterkörpers gebildet wird, eine sehr viel höhere Dotierungskonzentration als die Innenzone auf. Die Innenzone bzw. Driftzone, die wie eingangs erwähnt im wesentlichen die Sperrspannungsfestigkeit bestimmt, ist typischerweise epitaktisch aufgewachsen worden. Es ist auch denkbar, daß die Innenzone aus mehreren mit unter auch unterschiedlich stark dotierten Epitaxieschichten aufgebaut ist. In diesem Fall läßt sich durch die Anzahl der verschiedenen Epitaxieschichten sowie durch die eingestellte Dotierungskonzentration in der Innenzone die Sperrspannung beliebig einstellen.

Die Erfindung ist jedoch auch auf IGBTs und andere Leistungshalbleiterbauelemente anwendbar. Im Falle der IGBTs ist dann die Drainzone als Anodenzone ausgebildet. Diese Anodenzone ist vom entgegengesetzten Leitungstyp wie die Innenzone und weist typischerweise eine sehr hohe Dotierungskonzentration auf.

Die Erfindung weist weiterhin den Vorteil auf, daß durch einfaches Einbringen von bei vertikalen MOSFETs und IGBTs vorzugsweise gepaarten Ausräumzonen und Komplementärausräumzonen, insbesondere entlang des Strompfades, zum einen durch die Komplementärausräumzonen eine gute Leitfähigkeit gewährleistet wird und sich zum anderen bei einer Erhöhung der Drainspannung diese Bereiche gegenseitig ausräumen, wodurch eine hohe Sperrspannung gesichert bleibt. Da die Gesamtmenge der Dotierung in den Ausräumzonen in etwa der Gesamtmenge der Dotierung in den Komplementärausräumzonen entspricht, wird gewährleistet, daß bei einer Erhöhung der Drainspannung die derart gebildeten pn-Bereiche sich gegenseitig vollständig ausräumen, d. h. sich wie eine einzige Isolatorzone verhalten, wodurch eine hohe Sperrspannung gesichert bleibt.

Des Weiteren ist die Erfindung auf alle Arten von MOSFET, wie beispielsweise D-MOSFETs, V-MOSFETs, U-MOSFETs, etc. anwendbar.

Bevorzugte Ausgestaltungen und Weiterbildungen der Erfindung sind Kennzeichen der Unteransprüche.

Die Erfindung wird nachfolgend anhand der in den Figuren der Zeichnung angegebenen Ausführungsbeispiele näher erläutert. Es zeigt dabei:

Figur 1    einen Teilschnitt eines erfindungsgemäßen, vertikal ausgebildeten Halbleiterbauelementes, das hier als D-MOSFET (bzw. IGBT) ausgebildet ist;

Figur 2    in einer Draufsicht das Layout eines hexagonal ausgebildeten Zellenfeldes eines Halbleiterbauelementes entsprechend Figur 1 mit erfindungsgemäßen Abschattungsbereichen;

Figur 3    das Kleinsignal-Kennlinienfeld (im Sperrbe-trieb) eines mit Abschattungsbereichen ver-sehenen Halbleiterbauelementes (1) im Vergleich zu einem herkömmlichen Halblei-terbauelement ohne Abschattungsbereiche (2);

Figur 4    einen Teilschnitt für ein in Trenchtechnologie hergestellten vertikalen MOSFET;

Figur 5    eine Draufsicht eines weiteren hexagonal ausgebildeten Zellenfeldes.

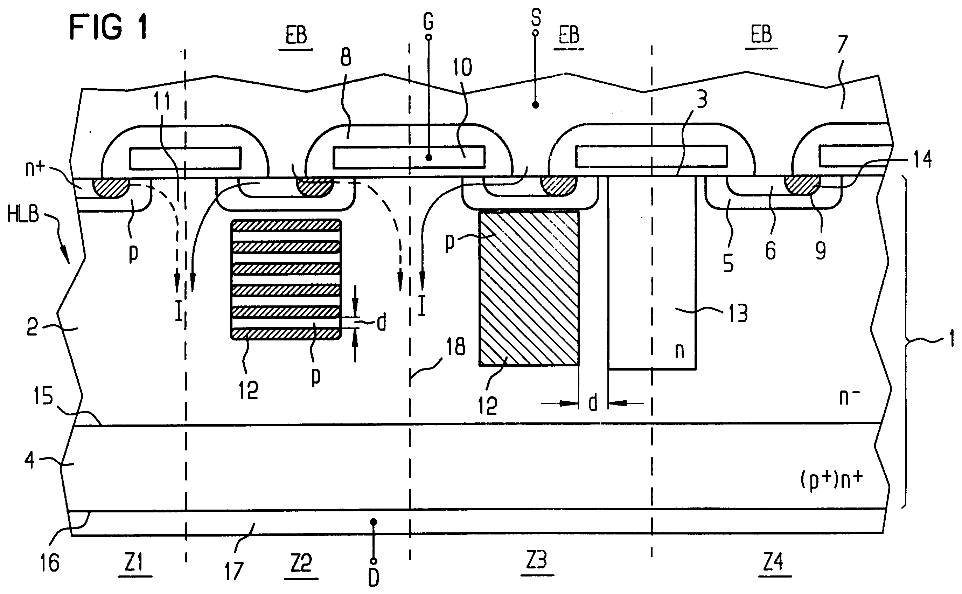

Figur 1 einen Teilschnitt eines erfindungs-gemäßen, vertikal ausgebildeten Leistungs-Halbleiter-bauelementes, das hier als D-MOSFET (bzw. IGBT) ausgebildet ist und mit HLB bezeichnet ist. Das Leistungs-Halbleiterbauelement HLB weist eine Vielzahl von parallel geschalteten und jeweils in einzelnen Zellen angeordneten Einzelbauelementen EB auf. Der Teilschnitt in Figur zeigt beispielhaft vier Zellen Z1...Z4 des Halbleiterbauelementes HLB.

In Figur 1 ist mit 1 der Halbleiterkörper des Halbleiterbauelementes HLB bezeichnet. Das vertikal ausgebildete Halblei-terbauelement HLB weist einen Sourceanschluß S, einen Gateanschluß G sowie einen Drainanschluß D auf, wobei Sourceanschluß S und Drainanschluß D an gegenüberliegenden Seiten des Halbleiterkörpers 1 angeordnet sind.

Der Halbleiterkörper 1, der beispielsweise aus Siliziumsubstrat besteht, weist eine im vorliegenden Ausführungsbeispiel schwach n-dotierte Innenzone 2 auf, die sourceseitig an die erste Oberfläche 3 des Halbleiterkörpers 1 angrenzt. Drainseitig grenzt eine Drainzone 4 an die Innenzone 2 an. Die Grenzfläche zwischen der Innenzone 2 und Drainzone 4 ist hier mit 15 bezeichnet.

Ist das Halbleiterbauelement HLB als MOSFET ausgebildet, dann ist die Drainzone 4 typischerweise stark n-dotiert. Ist das Halblei-terbauelement HLB ein IGBT, dann wird die Drainzone auch als Anodenzone bezeichnet und ist stark p-dotiert (wie in Klammern angedeutet), d. h. vom entgegengesetzten Leitungstyp wie die Innenzone. In diesem Fall charakterisiert die Grenzfläche 15 den pn-Übergang zwischen Drainzone 4 und Innenzone 2. Außerdem grenzt die Drainzone 4 an die zweite Oberfläche 16 des Halbleiterkörpers 1 und ist hier großflächig über eine Metallisierung bzw. Drainelektrode 17 mit dem Drainanschluß D verbunden.

Sourceseitig sind an die erste Oberfläche 3 eine Vielzahl von Basiszonen 5 eingebettet. Die Basiszonen 5 weisen einen der Innenzone 2 entgegengesetzten Leitungstyp auf, d. h. sie sind im gezeigten Fall p-dotiert. Die Basiszonen 5 sind im vorliegenden Aus-führungsbeispiel wannenförmig ausgebildet und kön-nen beispielsweise durch Ionenimplantation bzw. durch Diffusion hergestellt werden. Wie das Ausführungsbeispiel in Figur 1 zeigt, weist jede der Zellen Z1...Z4 typischerweise jedoch nicht notwendigerweise jeweils eine einzelne Basiszone 5 auf. Die Basiszonen 5 weisen hier eine entsprechende Zellenstruktur wie die Zellen Z1...Z4 auf. Solche Zellenstrukturen können streifenförmig, hexagonal, dreieckig, viereckig, rund, oval, etc. sein.

Im vorliegenden Ausführungsbeispiel ist in jeder der Basiszonen 5 jeweils eine wannenförmige, stark n-dotierte Sourcezone 6 eingebettet. Es wäre auch denkbar, daß jeweils mehrere Sourcezonen 6 in jeder der Basiszonen 5 eingebettet ist. Nachfolgend wird jedoch davon ausgegangen, daß jede Basiszone 5 jeweils nur eine Sourcezone 6, die beispielsweise über eine Arsenimplantation hergestellt wurde, enthält. Die Sourcezonen 6 weisen ebenfalls eine Zellenstruktur wie die Zellen Z1...Z4 auf. Die Sourcezonen 6 bzw. die Basiszonen 5 können jedoch auch grabenförmig, insbesondere V-grabenförmig, ausgebildet sein. Derartige Halbleiterbauelemente HLB werden auch als Trench-MOSFETs bzw. Trench-IGBTs bezeichnet.

Die Sourcezonen 6 und die Basiszonen 5 (in Figur 1 der Übersichtlichkeit heit halber nicht dargestellt) sind in bekannter Weise über ein Kontaktloch mit der Sourceelektrode 7 verbunden. Die Sourceelektrode 7 ist mit dem Sourceanschluß S verbunden. Es wäre auch denkbar, daß die Basiszonen 5 nicht von der Sourceelektrode 7 kontaktiert werden. Allerdings wird durch den Nebenschluß der Basiszone 5 und der Sourcezone 6 vermieden, daß parasitäre Bipolartransistoren unbeabsichtigt eingeschaltet werden.

Über der ersten Oberfläche 3 ist eine Gateelektrode 10 angeordnet, die über ein dünnes Gateoxid 8 gegen den Halbleiterkörper 1 sowie die Sourceelektrode 7 isoliert ist. Die Gateelektrode 10, die mit dem Gateanschluß G verbunden ist, kann beispielsweise aus hochdotiertem Polysilizium bzw. aus Metall bestehen.

Benachbarte Basiszonen 5 verschiedener Zellen Z1...Z4 sind über Zwischenzellenzonen 11 räumlich voneinander getrennt.

Des Weiteren können Ausräumzonen 12 und Komplementärausräumzonen 13 in der Innenzone 2 vorgesehen sein. In Figur 1 sind der Übersichtlichkeit halber diese Ausräumzonen 12 und Komplementärausräumzonen 13 nur in zwei der Zellen Z2, Z3 angedeutet. Außerdem wurden die Ausräumzonen 12 im Unterschied zu den Komplementärausräumzonen 13 schraffiert dargestellt.

In Zelle Z2 sind die Ausräumzonen und Komplementärausräumzonen 12, 13 im wesentlichen horizontal ausgebildet (Aufbautechnik), während sie in Zelle Z3 im wesentlichen vertikal ausgebildet sind. Die Ausräumzonen und Komplementärausräumzonen 12, 13 können miteinander in Kontakt stehen, d. h. sie können aneinander angeschlossen sein, sie müssen jedoch nicht aneinander angeschlossen sein. Sofern sie aneinander angeschlossen sind, bilden sie einen pn-Übergang.

Alle gezeigten Ausräumzonen 12 sind p-dotiert und alle gezeigten Komplementärausräumzonen 13 sind n-dotiert. Die Ausräumzonen 12 und Komplementärausräumzonen 13 können, wie in Zelle Z2 angedeutet, schichtförmig ausgebildet sein, oder wie in Zelle Z3 angedeutet fadenförmig bzw. streifenförmig ausgebildet sein. Es wäre jedoch denkbar, wenn die Ausräumzonen und Komplementärausräumzonen 12, 13 im wesentlichen kugelförmig ausgebildet sind. Im vorliegenden Ausführungsbeispiel befinden sich die Ausräumzonen und Komplementärausräumzonen 12, 13 im wesentlichen unterhalb des Bereiches der Basiszone 5. Es wäre selbstverständlich auch denkbar, wenn die Ausräumzonen und Komplementärausräumzonen 12, 13 ausschließlich in den Bereichen unterhalb der Zwischenzellenzonen 11 bzw. in der gesamten Innenzone 2 bzw. jeweils zum Teil unterhalb der Zwischenzellenzonen 11 und den Basiszonen 5 angeordnet sind.

Wesentlich ist hier, daß die Gesamtmenge der Dotierung der Ausräumzonen 12 in etwa der Gesamtmenge der Dotierung der Komplementärausräumzonen 13 entspricht, d. h. die vorzugsweise paarweise angeordneten Ausräumzonen 12 und Komplementärausräumzonen 13 verhalten sich wie eine einzige Isolatorzone, wodurch eine hohe Sperrspannung gesichert wird. Ferner ist zu beachten, daß die Summe der Volumenausdehnungen der eingebrachten Ausräumzonen 12 ungefähr gleich oder zumindest kleiner der der Komplementärausräumzonen 13 ist.

Für den Fall, daß die Ausräumzonen 12 und Komplementärausräumzonen 13 voneinander wie in Zelle Z3 beabstandet sind, sollte der Abstand d von jeweils zwei paarweise angeordneten Ausräumzonen und Komplementärausräumzonen 13 vorzugsweise kleiner als die Breite der Raumladungszone zwischen den Komplementärausräumzonen 13 und Ausräumzonen 12 bei der Durchbruchspannung zwischen den benachbarten Ausräumzonen 12 und Komplementärausräumzonen 13 sein. Vorzugsweise ist der Abstand d ebenfalls zu 0 zu wählen.

Die in den Zellen Z2 und Z3 gezeigten Ausräumzonen 12 sind "floatend", d. h. frei schwebend, ausgeführt und füllen daher nur einen Teil der Innenzonen 2 aus. Dies ist jedoch nicht notwendigerweise erforderlich. Im Fall, daß die Ausräumzonen 12 nichtfloatend ausgeführt sind, sind sie mindestens zum Teil an eine der Grenzfläche mit definiertem Potential, beispielsweise an die Grenzfläche 15 und/oder die Basiszone 5 angeschlossen. Die in Zelle Z3 gezeigte Komplementärausräumzone 13 hingegen ist nicht floatend ausgeführt, d. h. sie ist an die erste Oberfläche 3 des Halbleiterkörpers 1 angeschlossen.

Nachfolgend wird die Funktionsweise der in Figur 1 gezeigten Strukturen näher erläutert.

Bei kleiner Drainspannung ist die Leitfähigkeit in der Innenzone 2 ausreichend hoch, da die Komplementärausräumzonen 13 niedrohmig ausgebildet sind. Wird die Drainspannung zunehmend erhöht, dann räumen sich bei moderater Sperrspannung (beispielsweise kleiner 30 Volt), die Ausräumzonen 12 und Komplementärausräumzonen 13 gegenseitig aus. Bei einer weiteren Spannungserhöhung verstärkt sich nun das vertikale elektrische Feld ebenfalls. Die Sperrspannung wird dann von der Innenzone 2 aufgenommen.

Die genaue Funktion sowie die Struktur und die Herstellung derartiger Ausräumzonen 12 und Komplementärausräumzonen 13 ist detailliert in den eingangs genannten Dokumenten WO 97/29508 sowie US 4,754,310 beschrieben und wird hiermit ausdrücklich in den Gegenstand der vorliegenden Erfindung einbezogen („incorporated by reference").

Erfindungsgemäß sind in den Sourcezonen 6 in Figur 1 Abschattungsbereiche 9 vorgesehen. Die Abschattungsbereiche 9 innerhalb der Sourcezonen 6 sind jeweils schraffiert dargestellt. Die Abschattungsbereiche 9 nehmen einen Teil der Sourcezonen 6 ein. Die Abschattungsbereiche 9 sind typischerweise undotiert, können aber auch eine schwache Dotierungskonzentration vom selben Leitungstyp wie die Sourcezonen 6 aufweisen. Technologisch begründet weisen die Abschattungsbereiche 9 jedoch üblicherweise denselben Leitungstyp und dieselbe Dotierungskonzentration wie die Basiszonen 5 auf.

Die Abschattungsbereiche 9 sind vorzugsweise in den Randbereichen der Sourcezone 6 angeordnet und grenzen in diesen Bereichen zumindest seitlich an den pn-Übergang 14 zwischen Basiszone 5 und Sourcezone 6 an. Die Anordnung dieser Abschattungsbereiche 9 innerhalb der Sourcezonen 6 ist dabei wesentlich für deren Funktion.

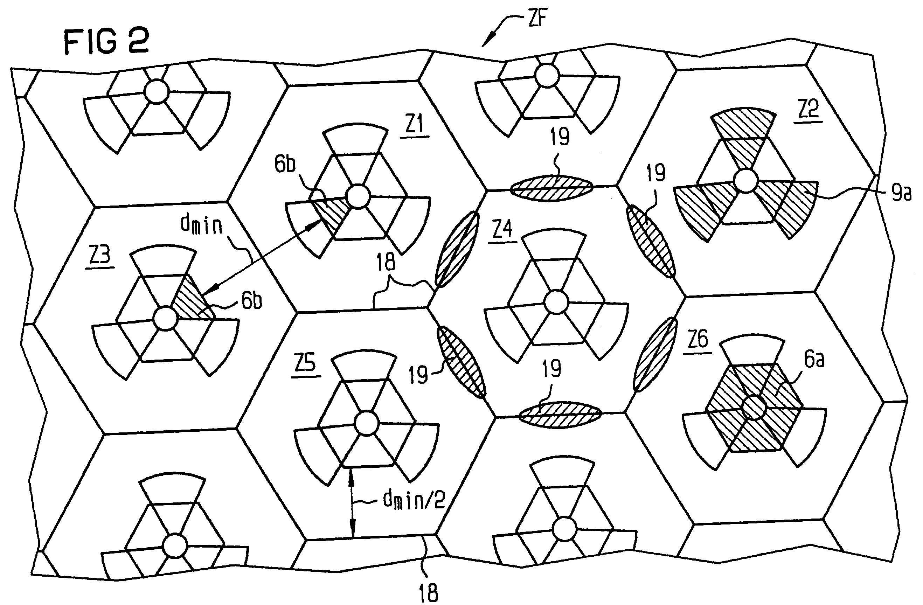

Die genau Struktur und Form der Abschattungsbereiche 9 bzw. deren Anordnung innerhalb des Zellenfeldes wird nachfolgend anhand von Figur 2 beschrieben. Figur 2 zeigt in einer Draufsicht das Layout des Zellenfeldes eines Halblei-terbauelementes HLB mit erfindungsgemäß vorgesehenen Abschattungsbereichen 9. Gleiche bzw. funktionsgleiche Elemente sind in Figur 2 mit gleichen Bezugszeichen versehen.

Das Zellenfeld in Figur 2 ist mit ZF bezeichnet.

Das Zellenfeld ZF weist eine hexagonale Zellenstruktur mit einer Vielzahl von hexagonal ausgebildeten Zellen, von denen beispielhaft einige Zellen Z1...Z6 mit Bezugszeichen versehen sind, auf.

Die Verwendung von hexagonalen Zellen Z1...Z4 erweist sich jedoch als besonders vorteilhaft, da es gegenüber anderen Zellstrukturen - beispielsweise dreieckigen oder quadratischen Zellen - in der Fläche eine höhere Parketierung bzw. eine optimale Flächenpackung aufweist.

Die Draufsicht des Zellenfeldes ZF markiert im Speziellen die (Implantations-)Maske zur Herstellung der Sourcezonen 6 mit den erfindungsgemäßen Abschattungsbereichen 9 an. Mit 6a sind dabei die für die Sourcezonen-Implantation vorgesehenen Bereiche bezeichnet (in der Zelle Z6 schraffiert dargestellt). Die für die Sourcezonen 6 vorgesehenen Bereiche 6a weisen hier - jedoch nicht notwendigerweise - dieselbe hexagonale Zellestruktur wie die Zellen Z1...Z6 des Zellenfeldes ZF auf.

Außerdem sind in der Implantationsmaske die Bereiche zur Herstellung der Abschattungsbereiche 9 mit 9a bezeichnet (in der Zelle Z2 schraffiert dargestellt). Diese Bereiche 9a haben eine dreiflügelige bzw. propellerähnliche Gestalt. Die Form und Fläche der so „abgeschatteten" Sourcezonenbereiche bestimmt im wesentlichen das W/L-Verhältnis in der jeweiligen Zelle, wobei mit W die Kanalweite W und mit L die Kanallänge bezeichnet ist.

Nachfolgend wird anhand der Figuren 1 und 2 die Funktionsweise der erfindungsgemäßen Halbleiterbauelemente HLB mit Abschattungsbereichen 9 erläutert.

Wird an ein Gateanschluß G ein positives Gatepotential angelegt, dann bildet sich in der Basiszone 5 unterhalb der Gateelektrode 10 zwischen Sourcezone 6 und Innenzone 2 ein Kanal 14 aus. Ein positives Drainpotential am Drainanschluß D führt dann zur Ausbildung eines Stromkanals in der Kanalzone 14, d. h. in den von der Gateelektrode 10 überdeckten Bereichen der Basiszonene 5. Das Halblei-terbauelement HLB schaltet also durch und es kommt zu einem zunächst im wesentlichen horizontalen verlaufenden Stromfluß von Majoritätsladungsträgern (Elektronen) von der Sourcezone 6 über den Stromkanal 14 zur Zwischenzellenzone 11.

Von der Zwischenzellenzone 11 wird der Strom dann im wesentlichen vertikal verlaufend von der Drainzone 4 abgesaugt. In diesem stromführenden Bereich der Innenzone 2, der sich unterhalb der Zwischenzellenzonen 11 befindet, bildet sich dann ein filamentartiger Stromfaden aus. Dieser filamentartige Strom ist in Figur 1 mit I bezeichnet.

Die Stromdichte des filamentartigen Stromes ist jedoch hier nicht homogen verteilt, da sich die Stromanteile von jeweils benachbarten Zellen zu den jeweiligen Gesamtstromdichte addieren. Insbesondere ist die Stromdichte unmittelbar im Bereich der Grenzfläche 18 zwischen zwei benachbarten Zellen am höchsten.

Benachbarte Zellen weisen darüberhinaus Sourceteilbereiche 6b (in den Zellen Z1 und Z3 schraffiert dargestellt) auf, bei denen die entsprechenden Sourcezonen 6 einen minimalen Abstand dmin zueinander besitzen. Zwischen diesen Sourceteilbereichen 6b treten dann die höchsten Stromdichten auf und zwar genau in der Mitte dmin/2 zwischen den beiden Sourceteilbereichen 6b. Dieser Bereich wird nachfolgend als kritischer Bereich 19 bezeichnet. Die kritischen Bereiche 19 der Zelle Z4 sind an deren Grenzflächen 18 schraffiert gekennzeichnet.

Das Halbleiterbauelement HLB müßte somit derart dimensioniert sein, daß in diesem kritischen Bereich 19 die kritische Stromdichte Jcrit nicht überschritten wird, obgleich in den Bereichen außerhalb des kritischen Bereichs 19 die Stromdichte infolge der inhomogenen Stromdichteverteilung mitunter weit unterhalb der kritischen Stromdichte Jcrit liegt.

Wie bereits erwähnt, weisen die Sourcezonen 6 zweier benachbarter Zellen Sourceteilbereiche 6b mit minimalem Abstand dmin der Sourcezonen 6 auf. Durch Einbringen von Abschattungsbereiche 9 bei genau einer der beiden Sourceteilbereiche 6b lassen sich dann die kritischen Bereiche 19 gezielt entschärfen. Dieser Sachverhalt ist in Figur 1 veranschaulicht. Dort sind die Abschattungsbereiche 9 jeweils nur im rechten Teil der Sourcezonen 6 angeordnet, während jeweils die linken Bereiche der Sourcezonen 6 frei sind von Abschattungsbereichen 9.

Dadurch, daß ausgewählte Sourceteilbereiche 6b mit Abschattungsbereichen 9 ausgestattet wurden, lassen sich die kritischen Bereiche 19 mit der höchsten Stromdichte gezielt entschärfen. Dies wird ebenfalls in Figur 1 deutlich. Dort bezeichnet der durchgezogener Pfeil den "nicht abgeschatteten" Stromanteil, während der gestrichelter Pfeil den „abgeschatteten" Stromanteil bezeichnet. Der abgeschattete Stromanteil weist eine gegenüber dem nicht abgeschatteten Stromanteil deutlich reduzierte Stromstärke auf, die im Extremfall sogar 0 betragen kann.

Durch diese Maßnahme werden insbesondere die kritische Stromdichten im kritischen Bereich 18 zwischen zwei benachbarten Zellen entschärft. Es wird somit eine wesentlich optimierte, d. h. homogenisierte Stromdichteverteilung im stromführenden Filament der Innenzone 2 gewährleistet.

Im Ausführungsbeispiel entsprechend Figur 2 weisen die für die Abschattung vorgesehenen Bereiche 9a ein dreiflügeliges Design auf. Das Design kann jedoch auch derart gewählt werden, daß jeweils größere oder kleinere Bereiche 9a der Sourcezonen 6 abgeschattet werden. Erfindungswesentlich ist lediglich, daß die für die n+-Sourceimplantation vorgesehenen Sourcebereiche 6a in jeder Zelle dergestalt abgeschattet werden, daß das effektive W/L-Verhältnis pro Zelle reduziert wird. Das dreiflügelige Design erweist sich daher infolge seiner symmetrischen Anordnung im Zellenfeld als besonders vorteilhaft.

Durch das dreiflügelige Design der Maske für die Abschattungsbereiche 9 wird jeweils einer der beiden, von den Sourcezonen 6 in die Basiszonen 5 injizierten Stromkanäle abgeschattet. Gleichzeitig wird durch eine mehrteilige Form der Maske die Frequentierung des Kanalstroms und somit des daraus resultierenden Gesamtstromes unterhalb der Zwischenzellenzonen 11 weitgehend homogen gestaltet.

Durch die strukturierte Abschattung jeder Zelle wird die Kanalweite W verringert und/oder die Kanalänge L in jeder Zelle vergrößert. In beiden Fällen verringert sich in der abgeschatteten Zelle das W/L-Verhältnis und damit auch der abgeschattete Stromanteil.

Sind die Abschattungsbereiche 9 undotiert, dann bildet sich in den abgeschatteten Bereichen der Sourcezone 6 keine Kanalzone 14 aus, daß heißt die effektive Kanalweite W der abgeschatteten Zelle verringert sich.

Für den Fall, daß die Abschattungsbereiche 9 zwar dieselbe, jedoch (deutlich) geringere Dotierungskonzentration vom selben Leitungstyp wie die Sourcezone 6 aufweisen, wird zwar ein Stromkanal 14 injiziert, jedoch fließt ein (weit) geringerer Strom. Das bedeutet, die „effektive", am Stromfluß beteiligte Kanalweite W ist ebenfalls geringer.

Undotierte Abschattungsbereiche 9 erweisen sich jedoch gegenüber schwach dotierten Abschattungsbereichen 9 als vorteilhafter, da bei ihrer Herstellung zumindest ein Technologieschritt eingespart werden kann. In beiden Fällen wird durch die strukturierte Abschattung der n⁺-implantierten Sourcezonen 6 in jeder Zelle die effektive Kanalweite W pro Zelle reduziert, da im abgeschatteten Bereich keine bzw. eine reduzierte Elektronenquelle für den Elektronenstrom zur Verfügung steht.

Über die Einstellung der Dotierungskonzentration der Abschattungsbereiche 9 sowie durch deren Design und Geometrie läßt sich also das (effektive) W/L-Verhältnis an dieser Stelle und somit der abgeschattete Stromanteil definiert reduzieren.

Der wesentliche Vorteil der erfindinngsgemäßen, strukturierten Abschattung der Sourcezonen 6 besteht darin, daß insbesondere bei MOS-Halbleiterbauelementen HLB, welche Ausräumzonen 12 bzw. Komplementärausräumzonen 13 entsprechend Figur 1 aufweisen, d. h. trotz drastisch verkleinerter Chipfläche sowie bei gleichbleibendem flächenbezogenen Durchlaßwiderstand RDS$_{on}$ eine rechteckige sogenannte „Safeoperating-Area" erzielt werden kann. In dieser Safeoperating-Area ist die Stromdichte optimal verteilt und liegt deutlich unterhalb der maximal zulässigen kritischen Stromdichte Jcrit.

Des Weiteren kann der Kurzschlußstrom auf einem sehr niedrigen Niveau begrenzt werden. Damit läßt sich die Robustheit der MOS-Halbleiterbauelemente HLB steigern, d. h. es läßt sich bei gleichen Anforderungen an den flächenbezogenen Durchlaßwiderstand RDS$_{on}$ und gleichbleibendem Nennstrom eine drastisch verringerte Chipfläche realisieren. Es lassen sich somit Zellstrukturen mit einem Zellraster Z$_R$ kleiner 20 μm realisieren. Auf diese Weise werden entsprechend deutliche Kostenvorteile erzielt.

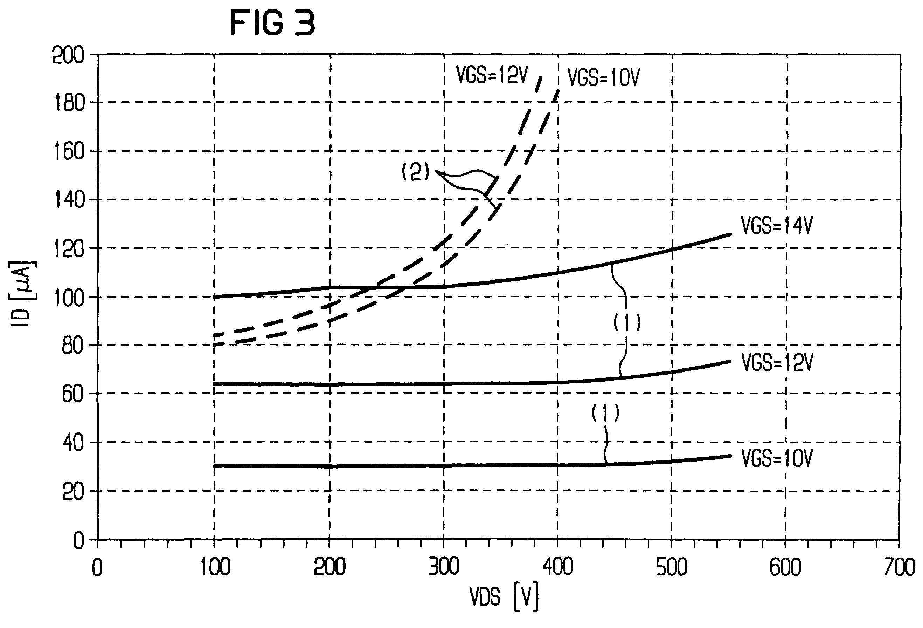

Figur 3 zeigt das Kleinsignal-Kennlinienfeld (im Sperrbetrieb) eines mit Abschattungsbereichen versehenen Halbleiterbauelementes (1) im Vergleich zu einem herkömmlichen Halbleiterbauelement ohne Abschattungsbereiche (2). Die dortigen Bauelemente sind jeweils für eine Sperrspannung von 600 V ausgelegt und weisen gleiche Dotierungskonzentrationen in den einzelnen Schichten sowie ein äquivalentes Zellenlayout auf.

Die Abszisse zeigt in Figur 3 die Drain-Source-Spannung VDS im Sperrfall, während die Ordinate den Drainstrom ID (Kleinsignal) für verschiedene Gate-Source-Spannungen VGS (VGS = 10V/12V/14V) der Halbleiterbauelemente zeigt. Es zeigt sich, daß die abgeschatteten Halbleiterbauelemente bis zur Sperrspannung von 500 V ohne nennenswerten Anstieg des Drainstromes betrieben werden können. Im Gegensatz dazu zeigen die herkömmlichen Halbleiterbauelemente einen mitunter sehr starken Anstieg des Drainstromes.

Insbesondere bei niedrigen Sperrspannungen - beispielsweise etwa 100 V in Figur 3 - weisen die abgeschatteten Halbleiterbauelemente einen sehr viel niedrigeren Drainstrom auf als die herkömmlichen Halbleiterbauelemente. Allerdings läßt sich der Drainstrom bei zunehmender Gate-Source-Spannungen VGS bis zum Erreichen einer Sättigung vergrößern. Vorteilhafterweise lassen sich die erfindinngsgemäßen Halbleiterbauelemente in die Strombereiche von herkömmlichen Halbleiterbauelementen jedoch ohne Stromfilamentierung steuern.

Im Ausführungsbeispiel in Figur 1 ist ein vertikaler D-MOSFET angegeben. Die Erfindung ist jedoch nahezu auf alle vertikal und lateral ausgeführten MOSFETs sowie auf IGBTs anwendbar. Denkbar wäre auch eine Verwendung bei bipolaren Halbleiterbauelementen.

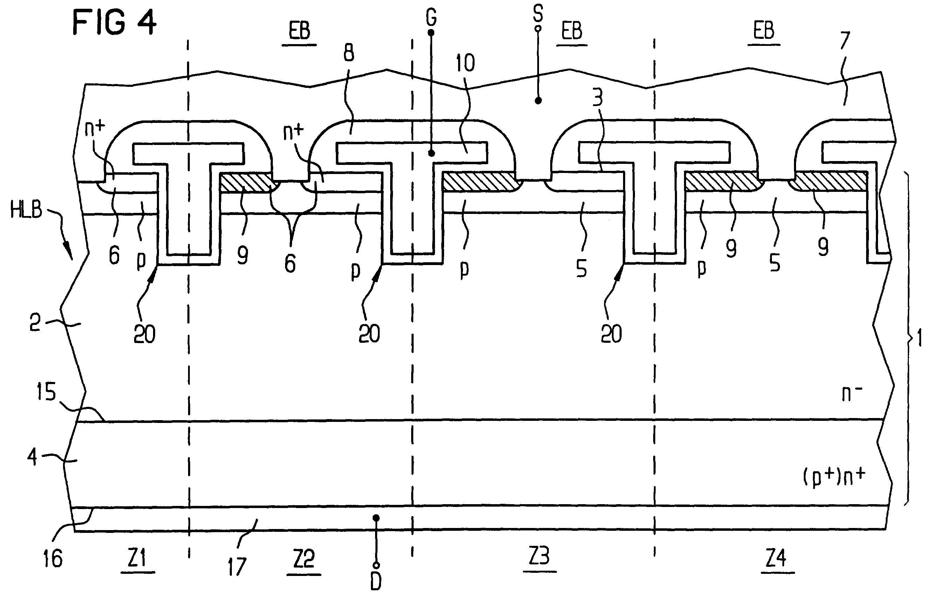

Figur 4 zeigt ein bevorzugtes Ausführungsbeispiel für ein in Trenchtechnologie hergestellten vertikalen MOSFET. Gleiche bzw. funktionsgleiche Elemente sind entsprechend Figur 1 und 2 mit gleichen Bezugszeichen versehen. Zur besseren Übersicht enthält Figur 3 nur die für die Beschreibung der Funktion des Halbleiterbauelementes relevante Merkmale.

Im Gegensatz zu Figur 1 ist hier die Gateelektrode 8 in einem Graben 20 angeordnet und ragt zapfenförmig in den Halbleiterkörper 1 hinein. Die Form der Gateelektrode 8 in den Gräben 20 kann unterschiedlich ausgestaltet sein. Sie können flaschenförmig sich in die Tiefe des Grabens 20 hin vergrößern oder sie können V-grabenförmig ausgebildet sein.

Ähnlich wie in Figur 1 weist auch das Halbleiterbauelement HLB in Figur 4 Abschattungsbereiche 9 innerhalb der Sourcezonen 6 auf. Dabei können die Sourcezonen 6 partiell abgeschattet sein, das heißt die Abschattungsbereiche 9 überdecken nur einen Teil der Sourcezonen 6. Dies ist in den Zellen Z2 und Z3 angedeutet. Es wäre jedoch auch denkbar, daß wie bei Zelle Z4 die Sourcezonen 6 vollständig abgeschattet sind. Es wäre auch denkbar, daß einige Zellen ganz frei sind von Abschattungsbereichen 9 (in Figur 4 nicht gezeigt).

Die Anordnung der Abschattungsbereiche 9 in Figur 2 ist symetrisch, wobei bei jeder Zelle insbesondere durch das dreiflügelige Design der Abschattungsmaske eine etwa gleich große Fläche der Sourcezonen 6 mit Abschattungsbereichen 9 versehen ist. Es lassen sich hier je nach Design der Maske für die Abschattungsbereiche eine Reduzierung der aktiven stromführenden Fläche des Halbleiterbauelementes HLB und somit eine Abschattung bis zu 50 % erzielen.

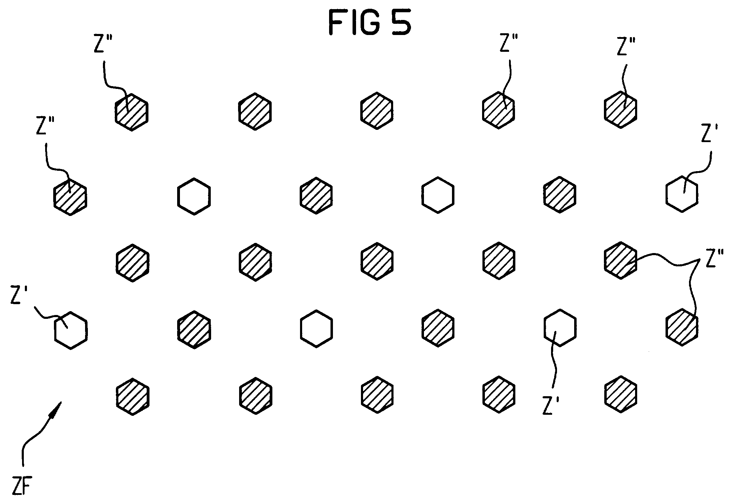

Figur 5 zeigt in einer Draufsicht eine Prinzipskizze eines weiteren hexagonal ausgebildeten Zellenfeldes ZF, bei dem eine höhere Abschattung erzielt werden kann. Gleiche bzw. funktionsgleiche Elemente sind entsprechend Figur 2 mit gleichen Bezugszeichen versehen.

Das Zellenfeld in Figur 5 ist entsprechend dem Zellenfeld in Figur 2 aufgebaut und weist eine Vielzahl von hexagonal ausgebildeten Zellen Z', Z" auf, die hier ebenfalls in dichtester Flächenpackung angeordnet sind. Die Zellen Z', Z" im Zellenfeld ZF sind in der Prinzipskizze in Figur 5 nur angedeutet.

Im Gegensatz zum Beispiel in Figur 2 sind jedoch in Figur 5 jeweils einzelne aktive Zellen Z' vorgesehen, bei denen keine Abschattungsbereiche in der Sourcezone vorgesehen sind. Im hexagonalen dichtest gepackten Zellenlayout ist jeweils eine Zelle des Zellenfeldes von jeweils sechs Zellen mit kürzesten Abstand umgeben. Im Ausführungsbeispiel in Figur 5 sind dabei die aktiven Zellen Z' umgeben von jeweils sechs inaktiven Zellen Z", bei denen die jeweiligen Sourcezonen typischerweise gänzlich abgeschattet sind. Diese Zellen sind in Figur 5 schraffiert dargestellt. Mit diesem Design des Zellenlayouts läßt sich somit eine Abschattung der Sourcezonen bis zu 66 % erreichen. Derartige Halbleiterbauelemente HLB weisen eine verbesserte Kurzschlußfestigkeit auf.

Die Ausführungsbeispiele in den Figuren 1, 2 und 4 beschreiben jeweils ein hexagonales Zellenlayout, das aus Geometriegründen wie oben beschrieben besonders vorteilhaft ist. Die Erfindung ist selbstverständlich nicht ausschließlich auf ein hexagonales Zellenfeldlayout beschränkt, sondern kann auch sehr vorteilhaft auch auf ein Zellenfeldlayout mit quadratischen, dreieckigen, rechteckigen, mehreckigen, etc. Zellen übertragen werden. Denkbar wäre auch ein Zellenlayout mit runden oder ovalen Zellen. In jedem Fall ist ein propellerähnliches Design der Abschattungsbereiche 9 - mit je nach Zellstruktur angepaßtem Design - von besonderem Vorteil.

## Patentansprüche

1. Durch Feldeffekt steuerbares Leistungs-Halbleiterbauelement (HLB), das eine Vielzahl von parallel geschalteten und jeweils in Zellen (Z1...Z6) angeordneten Einzelbauelementen (EB) aufweist, wobei die Zellen (Z1...Z6) in einem Zellenfeld (ZF) auf relativ kleinem Raum dicht gepackt angeordnet sind, bestehend aus einem Halbleiterkörper (1),

   a) mit mindestens einer Innenzone (2) vom ersten Leitungstyp, die mindestens teilweise an eine erste Oberfläche (3) des Halbleiterkörpers (1) angrenzt,

   b) mit mindestens einer Drain-Zone (4), die an die Innenzone (2) angrenzt,

   c) mit mindestens einer in jeder der Zellen (Z1...Z6) angeordneten Basiszone (5) vom zweiten Leitungstyp, die an der ersten Oberfläche (3) in den Halbleiterkörper (1) eingebettet sind,

   d) mit mindestens einer in jeder der Zellen (Z1...Z6) angeordneten Source-Zone (6) vom ersten Leitungstyp, die in den Basiszonen (5) eingebettet sind,

   e) mit mindestens einer Source-Elektrode (7), die jeweils die Basiszonen (5) und die darin eingebetteten Source-Zonen (6) kontaktiert,

   f) mit mindestens einer gegen den gesamten Halbleiterkörper (1) isolierten Gate-Elektrode (10),
   **dadurch gekennzeichnet, daß**

   g) zumindest in einer der Source-Zonen (5) der Zellen (Z1...Z4) Abschattungsbereiche (9) vorgesehen sind,

   h) die dort das effektive W/L-Verhältnis reduzieren, wobei mit W/L-Verhältnis das Verhältnis von Kanalweite W zu Kanallänge L bezeichnet ist.

2. Leistungs-Halbleiterbauelement nach Anspruch 1, **dadurch gekennzeichnet,** daß die Source-Zonen (6) zweier benachbarter Zellen (Z1...Z2) Sourceteilbereiche (6b) mit minimalem Abstand dmin der Source-Zonen (6) zueinander aufweisen, wobei jeweils einer der beiden Sourceteilbereiche (6b) Abschattungsbereiche (9) aufweist.

3. Leistungs-Halbleiterbauelement nach einem der vorherigen Ansprüche,

**dadurch gekennzeichnet,**
daß die Abschattungsbereiche (9) vom selben Leitungstyp wie die Source-Zonen (5) sind und eine sehr viel niedrigere Dotierungskonzentration aufweisen.

4. Leistungs-Halbleiterbauelement nach einem der Ansprüche 1 oder 2,
**dadurch gekennzeichnet,**
daß die Abschattungsbereiche (9) undotiert sind.

5. Leistungs-Halbleiterbauelement nach einem der vorherigen Ansprüche,
**dadurch gekennzeichnet,**
daß die Source-Zonen (6) und/oder die Abschattungsbereiche (9) arsendotiert sind.

6. Leistungs-Halbleiterbauelement nach einem der vorherigen Ansprüche,
**dadurch gekennzeichnet,**
daß jede der Zellen (Z1...Z4) genau eine Basis-Zone (5) und mindestens eine Source-Zone (6) aufweist, die etwa konzentrisch um den Mittelpunkt der jeweiligen Zelle angeordnet ist und deren Querschnittsflächen etwa der Querschnittsfläche der Zelle (Z1...Z4) entspricht.

7. Leistungs-Halbleiterbauelement nach einem der vorherigen Ansprüche,
**dadurch gekennzeichnet,**
daß das Zellenfeld (ZF) etwa hexagonale Zellen (Z1...Z4) aufweist.

8. Leistungs-Halbleiterbauelement nach einem der Ansprüche 1 bis 6,
**dadurch gekennzeichnet,**
daß das Zellenfeld (ZF) etwa quadratische Zellen (Z1...Z4) aufweist.

9. Leistungs-Halbleiterbauelement nach einem der vorherigen Ansprüche,
**dadurch gekennzeichnet,**
daß die Abschattungsbereiche (9) innerhalb einer Zelle (Z1...Z4) in der Ebene der ersten Oberfläche (3) eine propellerähnliche Gestalt aufweisen.

10. Leistungs-Halbleiterbauelement nach einem der vorherigen Ansprüche,
**dadurch gekennzeichnet,**
daß jede der Source-Zonen (5) der Zellen (Z1...Z4) des Zellenfeldes (ZF) Abschattungsbereiche (9) aufweist.

11. Leistungs-Halbleiterbauelement nach einem der vorherigen Ansprüche,
**dadurch gekennzeichnet,**
daß das Zellraster des Zellenfeldes (ZF) kleiner als 20 μm ist.

12. Leistungs-Halbleiterbauelement nach einem der vorherigen Ansprüche,
**dadurch gekennzeichnet,**
daß die Drain-Zone (4) eine Dotierung vom ersten Leitungstyp aufweist.

13. Leistungs-Halbleiterbauelement nach einem der vorherigen Ansprüche,
**dadurch gekennzeichnet,**
daß die Drain-Zone (4) eine wesentlich höhere Dotierungskonzentration als die Innenzone (2) aufweist.

14. Leistungs-Halbleiterbauelement nach einem der vorherigen Ansprüche,
**dadurch gekennzeichnet,**
daß die Innenzone (2) mindestens teilweise epitaktisch aufgewachsen ist.

15. Leistungs-Halbleiterbauelement nach einem der vorherigen Ansprüche,
**dadurch gekennzeichnet,**
daß in der Innenzone (2) mindestens eine Ausräumzone (12) vom zweiten Leitungstyp und mindestens eine Komplementärausräumzone (13) vom ersten Leitungstyp vorgesehen sind, wobei die Gesamtmenge der Dotierung der Ausräumzonen (12) in etwa der Gesamtmenge der Dotierung der Komplementärausräumzonen (13) entspricht.

16. Leistungs-Halbleiterbauelement nach einem der vorherigen Ansprüche,
**dadurch gekennzeichnet,**
daß das Zellenfeld (ZF) eine Vielzahl von aktiven Zellen (Z') aufweist, die frei sind von Abschattungsbereichen (9), und diese aktiven Zellen (Z') zumindest teilweise umgeben sind von zumindest teilweise inaktiven Zellen (Z"), wobei die zumindest teilweise inaktiven Zellen (Z") Abschattungsbereiche (9) aufweisen.

FIG 1

EP 0 939 446 A1

FIG 2

# FIG 3

EP 0 939 446 A1

FIG 4

FIG 5

Europäisches Patentamt

EUROPÄISCHER RECHERCHENBERICHT

Nummer der Anmeldung

EP 99 10 2696

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.6) |
|---|---|---|---|
| A | US 5 095 343 A (KLODZINSKI STANLEY J ET AL) 10. März 1992 * Abbildungen 2,3 * | 1,2,6,7, 9-14,16 | H01L29/08 H01L29/78 H01L29/739 |
| A | US 5 338 693 A (KINZER DANIEL M ET AL) 16. August 1994 * Zusammenfassung; Abbildung 13 * | 1-7, 9-14,16 | |
| A | EP 0 199 293 A (GEN ELECTRIC) 29. Oktober 1986 * Seite 9, Zeile 16 - Seite 10, Zeile 8; Abbildung 1 * | 1,2, 10-14 | |
| A | EP 0 098 497 A (SIEMENS AG) 18. Januar 1984 * Abbildung 3 * | 1-6, 8-11,13, 14,16 | |
| D,A | WO 97 29518 A (SIEMENS AG ;TIHANYI JENOE (DE); STRACK HELMUT (DE); GEIGER HEINRIC) 14. August 1997 * Zusammenfassung; Abbildungen 1,2 * | 1,15 | |

RECHERCHIERTE SACHGEBIETE (Int.Cl.6)

H01L

Der vorliegende Recherchenbericht wurde für alle Patentansprüche erstellt

| Recherchenort | Abschlußdatum der Recherche | Prüfer |
|---|---|---|
| BERLIN | 12. Mai 1999 | Polesello, P |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument
........................................................................
& : Mitglied der gleichen Patentfamilie, übereinstimmendes Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**                    EP 99 10 2696

In diesem Anhang sind die Mitglieder der Patentfamilien der im obengenannten europäischen Recherchenbericht angeführten
Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

12-05-1999

| Im Recherchenbericht angeführtes Patentdokument | | Datum der Veröffentlichung | Mitglied(er) der Patentfamilie | | Datum der Veröffentlichung |
|---|---|---|---|---|---|
| US 5095343 | A | 10-03-1992 | KEINE | | |
| US 5338693 | A | 16-08-1994 | US | 5475252 A | 12-12-1995 |
| EP 0199293 | A | 29-10-1986 | JP | 6093511 B | 16-11-1994 |
| | | | JP | 61281557 A | 11-12-1986 |
| EP 0098497 | A | 18-01-1984 | DE | 3224618 A | 05-01-1984 |
| | | | JP | 3062026 B | 24-09-1991 |
| | | | JP | 59021069 A | 02-02-1984 |
| | | | US | 4584593 A | 22-04-1986 |
| WO 9729518 | A | 14-08-1997 | DE | 19604043 A | 07-08-1997 |
| | | | DE | 19604044 A | 14-08-1997 |
| | | | EP | 0879481 A | 25-11-1998 |

EPO FORM P0461

Für nähere Einzelheiten zu diesem Anhang : siehe Amtsblatt des Europäischen Patentamts, Nr.12/82